(19) Europäisches Patentamt / European Patent Office / Office européen des brevets

(11) **EP 3 496 120 B1**

(12) **EUROPEAN PATENT SPECIFICATION**

(45) Date of publication and mention
of the grant of the patent:
**03.05.2023 Bulletin 2023/18**

(21) Application number: **17836926.0**

(22) Date of filing: **31.07.2017**

(51) International Patent Classification (IPC):
*H01G 9/20* *(2006.01)*     *B32B 37/00* *(2006.01)*

(52) Cooperative Patent Classification (CPC):
**H01G 9/2068;** B32B 37/12; H01G 9/2031;
H01G 9/2059; H01G 9/209; Y02E 10/542;
Y02E 10/549

(86) International application number:
**PCT/JP2017/027775**

(87) International publication number:
**WO 2018/025821 (08.02.2018 Gazette 2018/06)**

(54) **SOLAR CELL MODULE, AND METHOD FOR PRODUCING SOLAR CELL MODULE**

SOLARZELLENMODUL UND VERFAHREN ZUR HERSTELLUNG DES SOLARZELLENMODULS

MODULE DE CELLULE SOLAIRE ET PROCÉDÉ DE FABRICATION DE MODULE DE CELLULE SOLAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.08.2016 JP 2016152172**

(43) Date of publication of application:
**12.06.2019 Bulletin 2019/24**

(73) Proprietor: **Zeon Corporation
Tokyo 100-8246 (JP)**

(72) Inventors:
• **MATSUO, Takatoshi
Tokyo 100-8246 (JP)**
• **YAMAAI, Midori
Tokyo 100-8246 (JP)**

(74) Representative: **Maiwald GmbH
Elisenhof
Elisenstraße 3
80335 München (DE)**

(56) References cited:
WO-A1-2009/144899     WO-A1-2012/111781
CN-A- 101 763 951     DE-A1-102014 204 125
JP-A- 2008 186 763     JP-A- 2008 186 764
JP-A- 2011 076 727     JP-A- 2015 082 367
US-A1- 2010 132 785     US-A1- 2010 282 417
US-A1- 2011 120 550

**Description**

TECHNICAL FIELD

The present disclosure relates to a dye-senitized solar cell module and a method of producing a dye-senitized solar cell module.

BACKGROUND

In recent years, solar cells have been attracting interest as photoelectric conversion elements that convert light energy to electrical power. Among solar cells, those in which resin films are used as substrates benefit from having light weight and flexibility. Examples of solar cells in which resin films are used as substrates include dye-sensitized solar cells, organic thin-film solar cells, and perovskite solar cells. These solar cells normally have a cell structure in which a functional layer that contributes to electron or hole transfer is sandwiched between two electrodes. More specifically, in the case of a dye-sensitized solar cell, the solar cell includes an electrolyte layer as a functional layer. Moreover, in the case of an organic thin-film solar cell or a perovskite solar cell, the solar cell includes a donor layer and an acceptor layer as functional layers.

A solar cell is normally used in the form of a solar cell module that includes one or more cells and lead-out electrodes that are respectively connected to two electrodes, or in the form of a solar cell array in which multiple solar cell modules are connected in series or parallel.

In regards to dye-sensitized solar cell modules, which are one type of solar cell module, it has been proposed that the entirety of the solar cell module is protected using a thin film in order to protect the solar cell module from the external environment and also in order to retain the initial photoelectric conversion efficiency of the dye-sensitized solar cell in an actual installation environment (for example, refer to PTL 1). In PTL 1, a solar cell module is sandwiched from above and below by at least one moisture-proof film, and lead materials forming lead-out electrodes extend externally through penetrations at two or more locations. In the solar cell module of PTL 1, the peripheral edge of the moisture-proof film including the penetrations at two locations is heat sealed along the entire perimeter thereof. More specifically, a sheet-shaped seal member made from synthetic resin is disposed between a lead material and a moisture-proof film that sandwiches the solar cell module from above and below and has a polyolefinic resin stacked at an innermost layer thereof. The seal member is sealed by heat sealing of resins at the moisture-proof film. PTL 2 and PTL 3 disclose further solar cell module structures.

CITATION LIST

Patent Literature

PTL 1: JP 2008-186764 A
PTL 2: US 2011/120550 A1
PTL 3: US 2010/132785 A1

SUMMARY

(Technical Problem)

There is demand for reduction of sealing width in order to improve the area fraction of an electricity generating part in a solar cell module. In a situation in which sealing width is reduced, it is also necessary to reduce sealing cross-sectional area in order to inhibit infiltration of moisture and the like and maintain reliability. When sealing is performed through thermal bonding of resin using a heat sealing member that is disposed around a lead material as in PTL 1, it has been demonstrated that if the thickness of the seal member is reduced in order to reduce the sealing cross-sectional area, a gap at a step section with a film formed due to the thickness of the lead material cannot be adequately filled by the seal member, and thus a void is formed, and close adherence between a lead-out electrode and a moisture-proof film is inadequate. In PTL 1, an attempt is made to avoid the formation of gaps through the seal member sticking out to a certain degree, but when the degree to which the seal member sticks out increases, the sealing cross-sectional area at that part also becomes wider by an amount corresponding to the thickness of the seal member. When a solar cell module having inadequate tight sealing between a lead-out electrode and a moisture-proof film is used in an actual installation environment, photoelectric conversion efficiency of the solar cell module gradually deteriorates, and sufficient photoelectric conversion efficiency cannot be retained. In other words, the solar cell module cannot display an adequate photoelectric conversion efficiency retention rate (hereinafter also referred to simply as "efficiency retention").

Accordingly, an objective of the present disclosure is to provide a solar cell module that includes a barrier packaging material protecting the solar cell module from the external environment and that has an excellent photoelectric conversion efficiency retention rate.

(Solution to Problem)

The invention is set out in the appended claims. The present disclosure aims to advantageously solve the problem set forth above by disclosing a solar cell module comprising: one or more photoelectric conversion cells in which a first electrode at a side of a first base plate and a second electrode at a side of a second base plate are in opposition via a functional layer; at least one barrier packaging material that is sealed by a seal and encloses the one or more photoelectric conversion cells; a first lead-out electrode connected to the first electrode via a first electrical connector; and a second lead-out electrode connected to the second electrode via a second electrical connector, wherein the functional layer is an electrolyte layer and the solar cell module is a dye-sensitized solar cell module, the first lead-out electrode and the second lead-out electrode each include a conductor, and the barrier packaging material includes at least one seal that extends either or both of the first lead-out electrode and the second lead-out electrode from the solar cell module, and at which a gap between each of the conductors and the barrier packaging material is filled by a cured product of a crosslinkable adhesive composition, wherein each of the first electrical connector and the second electrical connector includes conductive pressure-sensitive adhesive, and the at least one seal has a thickness of at least 1 $\mu$m and not more than 250 $\mu$m. By sealing the gap between the barrier packaging material and the conductor at the seal with a cured product of a crosslinkable adhesive composition in this manner, the sealing cross-sectional area can be reduced while filling between the conductor and the barrier packaging material without leaving a void therebetween, particularly at a step section of the seal resulting from the thickness of the conductor, and a solar cell module having a high photoelectric conversion efficiency retention rate can be obtained.

The term "non-conductive" as used in the present specification means having volume resistance such that leakage current that may negatively affect solar cell characteristics does not flow. For example, "non-conductive" may refer to a volume resistance of $10^7$ $\Omega\cdot$cm or more.

In the presently disclosed solar cell module, the first base plate and the second base plate preferably each include a resin film. Barrier performance of a substrate itself is poorer with a resin film than with substrates such as glass. However, when base plates of a solar cell module having a structure such as disclosed herein are formed using resin films, it is possible to increase barrier performance while also providing the solar cell module with weight-reduction and flexibility.

In the presently disclosed solar cell module, the first electrical connector and the second electrical connector preferably each contain a conductive resin. When the electrical connector between each electrode and lead-out electrode contains a conductive resin, conductivity between the electrodes and the lead-out electrodes can be increased.

The term "conductive" as used in the present specification indicates that electrical connection is possible in at least the connection direction, and lower electrical resistance is preferable from a viewpoint of solar cell characteristics. For example, when a solar cell module is formed using a conductive resin or through curing of a subsequently described conductive resin composition, resistance of the conductive resin or cured conductive resin composition in the connection direction should not cause significant deterioration of characteristics of the solar cell module. Specifically, the unit area resistance of the conductive resin or the cured conductive resin composition is preferably 0.5 $\Omega\cdot$cm$^2$ or less. The unit area resistance can be determined from a value measured by a resistivity meter at both ends in the connection direction and the cross-sectional area in a direction perpendicular to the connection direction.

In the presently disclosed solar cell module, the first electrical connector and the second electrical connector preferably each contain solder. The photoelectric conversion efficiency of the solar cell module can be further increased when solder is used to form the electrical connectors between the electrodes and the lead-out electrodes.

In the presently disclosed solar cell module, the crosslinkable adhesive composition is preferably a photocurable resin composition. When the crosslinkable adhesive composition is a photocurable resin composition, degradation due to heating during production can be prevented, particularly in production of an organic solar cell, and electrical characteristics of the solar cell module can be improved. Moreover, it is expected that a solar cell module having good production efficiency will be obtained because a photocurable resin composition can be cured in a short time.

In the presently disclosed solar cell module, the at least one seal has a thickness of at least 1 $\mu$m and not more than 250 $\mu$m. When the thickness of the seal is within the range set forth above, permeation of moisture to the inside of the solar cell module can be inhibited, and efficiency retention of the solar cell module can be further increased.

The "thickness" of the seal referred to in the present specification is a value obtained by, in a sealing cross-section, determining the minimum distance between barrier packaging materials and the minimum distance between a barrier packaging material and a lead-out electrode in a thickness direction of the solar cell module, and then calculating an average value of these distances.

The presently disclosed solar cell module preferably further comprises an adhesive layer disposed in at least part of a gap between the barrier packaging material and either or both of the first base plate and the second base plate. Sealing and efficiency retention of the solar cell module can be further improved when an adhesive layer is interposed between the barrier packaging material and each of the base plates. Moreover, reflection can be suppressed and light transmission into the module can be improved by selecting a material in consideration of the relationship with the refractive index of a substrate.

In the presently disclosed solar cell module, the functional layer is an electrolyte layer and the solar cell module is a dye-sensitized solar cell module.

Moreover, the present disclosure aims to advantageously solve the problems set forth above by disclosing a method of producing a solar cell module that is a method of producing any one of the solar cell modules set forth above comprising: an application step of applying the crosslinkable adhesive composition onto the barrier packaging material; a sandwiching step of using the barrier packing material to sandwich a pair of base plates including the first base plate that includes the first lead-out electrode and the second base plate that includes the second lead-out electrode from upper and lower surfaces of the pair of base plates; and a pressing close adhesion step of closely adhering the barrier packing material to the conductor of the first lead-out electrode and the conductor of the second lead-out electrode via the crosslinkable adhesive composition while pressing the pair of base plates in a thickness direction via the barrier packaging material using a pressing member, wherein the pressing member is formed of silicone rubber and includes a recess that fits with the pair of base plates in at least a pressed state.

The production method set forth above enables favorable production of the presently disclosed solar cell module.

In the presently disclosed method of producing a solar cell module, the pressing member is formed of silicone rubber. When the pressing member that presses the solar cell module in the thickness direction is silicone rubber, a recess that fits with the base plates can easily and favorably be formed through pressing, and tight sealing of the solar cell module can be improved.

In the presently disclosed method of producing a solar cell module, the pressing member preferably has higher hardness in a region that does not come into contact with the pair of base plates than in a region that does come into contact with the pair of base plates. When the hardness of a region that does not come into contact with the pair of base plates is higher than the hardness of a region that does come into contact with the pair of base plates, the seal can be formed more favorably, and tight sealing of the solar cell module can be improved.

In the presently disclosed method of producing a solar cell module, the pressing member preferably includes a recess that fits with the pair of base plates in a non-pressed state. Production efficiency of the solar cell module can be improved when the pressing member already includes a recess that fits with the base plates.

In the presently disclosed method of producing a solar cell module, the crosslinkable adhesive composition preferably has a viscosity of at least 10 Pa·s and not more than 200 Pa·s. When the pre-curing viscosity of the crosslinkable adhesive composition is within the range set forth above, dripping in the application step can be prevented, the crosslinkable adhesive composition can be applied with a desired application thickness, close adherence between the conductors and the barrier packaging material can be improved, and efficiency retention of the solar cell module can be further increased.

In the presently disclosed method of producing a solar cell module, it is preferable that a first lead-out electrode on which a formation material of the first electrical connector is partially disposed in advance and a second lead-out electrode on which a formation material of the second electrical connector is partially disposed in advance are used. Production efficiency of the solar cell module can be further improved by forming a lead-out electrode on which a formation material of an electrical connector is partially disposed in advance.

(Advantageous Effect)

According to the present disclosure, it is possible to provide a solar cell module having high efficiency retention and a method of producing a solar cell module having high efficiency retention.

BRIEF DESCRIPTION OF THE DRAWINGS

In the accompanying drawings:

FIG. 1 is a plan view illustrating one example of schematic structure of a solar cell module according to one embodiment of the present disclosure;
FIG. 2 is a cross-sectional view II-II illustrating one example of schematic structure of the solar cell module illustrated in FIG. 1;
FIG. 3 is a cross-sectional view III-III illustrating one example of schematic structure of the solar cell module illustrated in FIG. 1; and

FIG. 4 is a cross-sectional view IV-IV for facilitating description of a method of measuring the thickness of a seal of the solar cell module illustrated in FIG. 1.

DETAILED DESCRIPTION

The following provides a detailed description of embodiments of the present disclosure based on the drawings. The presently disclosed solar cell module is, without any specific limitations, a dye-sensitized solar cell module. Moreover, the presently disclosed solar cell module may be a solar cell module that includes a plurality of photoelectric conversion cells (hereinafter also referred to simply as "cells") in series connection and may, for example, be a solar cell module having a Z-type integrated structure. Examples of possible integrated structures of the solar cell module besides that of a Z-type module include a series connection structure such as that of a W-type module or a monolithic module, and a parallel connection structure, but are not specifically limited thereto.

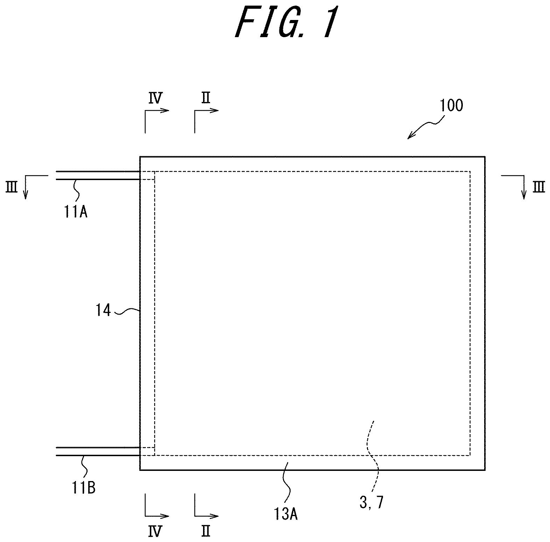

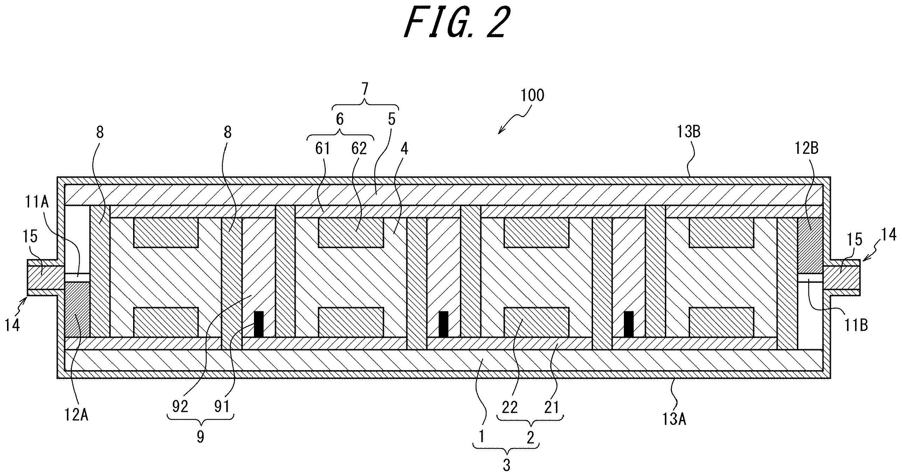

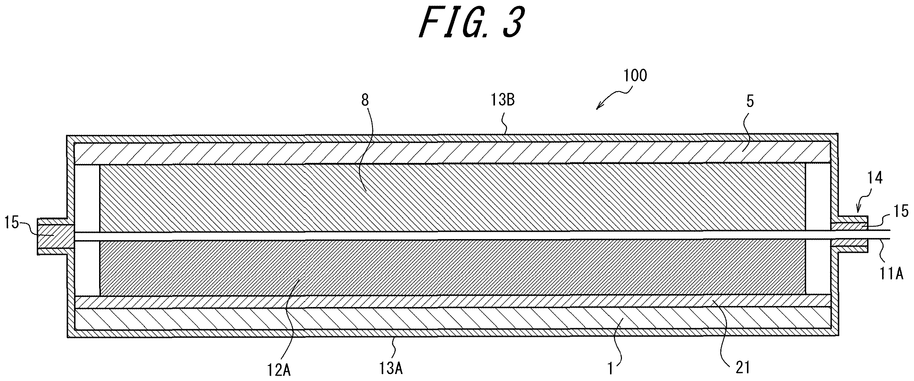

Moreover, examples of a dye-sensitized solar cell module having a Z-type integrated structure that is one example of the present disclosure include, but are not specifically limited to, a solar cell module 100 illustrated by the plan view in FIG. 1 and the thickness direction cross-sectional views in FIGS. 2 and 3.

(Solar cell module)

The solar cell module 100 illustrated in the plan view of FIG. 1 includes a barrier packaging material 13A and a barrier packaging material 13B (not illustrated in FIG. 1) that enclose a first base plate 3 (photoelectrode base plate) and a second base plate 7 (counter electrode base plate), and also includes a seal 14 that extends, from the solar cell module 100 to outside of the module, a first lead-out electrode 11A that is connected to the first base plate 3 and a second lead-out electrode 11B that is connected to the second base plate 7.

FIG. 2 is a cross-sectional view along a cutting line II-II in FIG. 1 and FIG. 3 is a cross-sectional view along a cutting line III-III in FIG. 1. As clearly illustrated in FIG. 2, the solar cell module 100 is a dye-sensitized solar cell module including a plurality of cells (four in the illustrated example) that are defined by partitions 8 and are connected in series, and has what is referred to as a "Z-type integrated structure". The solar cell module 100 has a structure in which the first base plate 3 including a first substrate 1 and a plurality of photoelectrodes (first electrodes) 2 (four in the illustrated example) disposed on the first substrate 1 with separation between the individual photoelectrodes 2 and the second base plate 7 including a second substrate 5 and a plurality of counter electrodes (second electrodes) 6 (four in the illustrated example) disposed on the second substrate 5 with separation between the individual counter electrodes 6 are pasted together in a state with the partitions 8 interposed between the first base plate 3 and the second base plate 7 such that the photoelectrode 2 and the counter electrode 6 of each cell are in opposition via an electrolyte layer (functional layer) 4 (i.e., such that a cell is formed) and such that a cell connector 9 electrically connects the photoelectrode 2 of one cell and the counter electrode 6 of another cell among adjacent cells. Each cell of the solar cell module 100 includes a photoelectrode 2, a counter electrode 6 in opposition to the photoelectrode 2, and an electrolyte layer 4 disposed between the photoelectrode 2 and the counter electrode 6.

The solar cell module 100 also includes a first lead-out electrode 11A that is connected to a photoelectrode conductive layer 21 of a photoelectrode 2 via a first electrical connector 12A, and a second lead-out electrode 11B that is connected to a counter electrode conductive layer 61 of a counter electrode 6 via a second electrical connector 12B. As clearly illustrated in FIG. 3, the barrier packaging materials 13A and 13B include a seal 14 that extends the first lead-out electrode 11A from the solar cell module 100. Although not illustrated in FIG. 3, the seal 14 also extends the second lead-out electrode 11B from the solar cell module 100. A feature of the seal 14 is that the seal 14 is sealed by a cured product of a crosslinkable adhesive composition. As clearly illustrated in FIG. 1, the seal 14 surrounds the periphery of the solar cell module 100 and separates the solar cell module 100 and the external environment.

It should be noted that the structure of the presently disclosed solar cell module is not limited to the structure illustrated in FIGS. 1 to 3. For example, although the first lead-out electrode 11A and the second lead-out electrode 11B extend from the same edge of the seal 14 formed at the periphery of the solar cell module 100 as illustrated in FIG. 1, the solar cell module 100 may alternatively have a structure in which the first lead-out electrode 11A and the second lead-out electrode 11B extend from different edges of the seal 14. Moreover, the first and second lead-out electrodes 11A and 11B are both disposed roughly centrally in the thickness direction of the solar cell module 100 in FIG. 2. However, the first lead-out electrode 11A is not specifically limited so long as the first lead-out electrode 11A is electrically connected to a photoelectrode 2 and insulated from the counter electrodes 6, and may be disposed at a position that is closer to the second substrate 5 than to the first substrate 1. Conversely, the second lead-out electrode 11B may be disposed at a position that is closer to the first substrate 1 than to the second substrate 5.

<First base plate>

The first base plate 3 of the solar cell module 100 illustrated in FIGS. 1 to 3 includes a first substrate 1 and a plurality of photoelectrodes 2 that is disposed on the first substrate 1 with separation between the individual photoelectrodes 2. The photoelectrodes 2 each include a photoelectrode conductive layer 21 disposed on the first substrate 1 and a porous semiconductor fine particulate layer 22 disposed on part of the photoelectrode conductive layer 21. Note that photoelectrode conductive layers 21 are disposed with gaps therebetween. Moreover, adjacent photoelectrodes 2 are disposed such as to be electrically insulated from one another. This electrical insulation may be achieved, for example, through partitions 8 that are present in the gaps between adjacent photoelectrode conductive layers 21, but is not specifically limited to being achieved in this manner.

A substrate used as the first substrate 1 may be selected as appropriate from commonly known light-transmitting substrates without any specific limitations. For example, a known transparent substrate that has transparency in the visible region, such as a transparent resin or glass, may be used as the first substrate 1. Of such substrates, a transparent resin that has been shaped into the form of a film (i.e., a resin film) is preferable as the first substrate 1. Although barrier performance of a substrate itself is poorer with a resin film than with substrates such as glass, barrier performance can be significantly improved through adoption of the presently disclosed structure. Moreover, the adoption of a resin film as the first substrate 1 can provide the solar cell module with weight-reduction and flexibility, and thereby enable use of the solar cell module in various applications.

Examples of transparent resins that may be used to form a resin film include synthetic resins such as polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), transparent polyimide (PI), and cycloolefin polymer (COP).

The photoelectrode conductive layer 21 is not specifically limited and may be obtained by forming a conductive layer composed of a metal mesh containing Au, Ag, Cu, or the like, a conductive layer formed through application of metal nanoparticles such as Ag nanoparticles, fine Ag wire, or the like, a conductive layer containing a composite metal oxide such as indium tin oxide (ITO), indium zinc oxide (IZO), or fluorine-doped tin oxide (FTO), a carbon-based conductive layer containing carbon nanotubes, graphene, or the like, or a conductive layer containing a conductive polymer such as PEDOT/PSS (poly(3,4-ethylenedioxythiophene) polystyrene sulfonate). These materials may be selected as appropriate depending on compatibility with other materials and so forth. A plurality of such conductive layers may be stacked on a substrate. Alternatively, various conductive materials such as described above that can be used to form these conductive layers may be mixed and then used to form a single conductive layer.

The photoelectrode conductive layer 21 may be formed on the first substrate 1 by a known formation method such as a method using a combination of sputtering and etching or screen printing.

An undercoat layer (not illustrated) may optionally be disposed on the photoelectrode conductive layer 21. In a case in which the subsequently described electrolyte layer 4 is formed by a liquid, electrolyte solution may reach the photoelectrode conductive layer 21 through the porous semiconductor fine particulate layer 22, and an internal short-circuit phenomenon referred to as reverse electron transfer, in which electrons leak from the photoelectrode conductive layer 21 into the electrolyte layer 4, may occur. This may generate a reverse current that is unrelated to photoirradiation and reduce photoelectric conversion efficiency. The internal short-circuit phenomenon can be prevented by providing the undercoat layer on the photoelectrode conductive layer 21. Provision of the undercoat layer on the photoelectrode conductive layer 21 can also improve close adherence between the porous semiconductor fine particulate layer 22 and the photoelectrode conductive layer 21.

The undercoat layer is not specifically limited so long as it is a substance that can prevent the internal short-circuit phenomenon (substance for which an interface reaction does not readily occur). For example, the undercoat layer may be a layer containing a material such as titanium oxide, niobium oxide, or tungsten oxide. The undercoat layer may be formed by a method in which the aforementioned material is directly sputtered onto a transparent conductive layer or a method in which a solution obtained by dissolving the aforementioned material in a solvent, a solution obtained by dissolving a metal hydroxide that serves as a precursor of a metal oxide, or a solution containing a metal hydroxide obtained by dissolving an organometallic compound in a mixed solvent containing water is applied onto the photoelectrode conductive layer 21, dried, and then sintered as necessary.

The porous semiconductor fine particulate layer 22 on which a sensitizing dye is supported (adsorbed) is not specifically limited and may be a porous semiconductor fine particulate layer that is obtained through adsorption of a sensitizing dye such as an organic dye or a metal complex dye by a porous semiconductor fine particulate layer containing particles of an oxide semiconductor such as titanium oxide, zinc oxide, or tin oxide. Examples of organic dyes that may be used include cyanine dyes, merocyanine dyes, oxonol dyes, xanthene dyes, squarylium dyes, polymethine dyes, coumarin dyes, riboflavin dyes, and perylene dyes. Examples of metal complex dyes that may be used include phthalocyanine complexes and porphyrin complexes of metals such as iron, copper, and ruthenium. Representative examples of sensitizing dyes include N3, N719, N749, D102, D131, D150, N205, HRS-1, and HRS-2. It is preferable that an organic solvent in which the sensitizing dye is dissolved is subjected to degassing and purification by distillation in advance in order to remove moisture and gas present in the solvent. Preferable examples of solvents that may be used as the organic solvent include alcohols such as methanol, ethanol, and propanol, nitriles such as acetonitrile, halogenated hydrocarbons, ethers, amides, esters, carbonate esters, ketones, hydrocarbons, aromatics, and nitromethane.

The porous semiconductor fine particulate layer 22 may be formed on the photoelectrode conductive layer 21 by a known formation method such as screen printing or coating. Moreover, adsorption of the sensitizing dye by the porous semiconductor fine particulate layer may be achieved by a known method such as immersion of the porous semiconductor fine particulate layer in a solution containing the sensitizing dye.

<Second base plate>

The second base plate 7 of the solar cell module 100 includes a second substrate 5 and a plurality of counter electrodes 6 that is disposed on the second substrate 5 with separation between the individual counter electrodes 6. The counter electrodes 6 each include a counter electrode conductive layer 61 disposed on the second substrate 5 and a catalyst layer 62 disposed on part of the counter electrode conductive layer 61. The catalyst layer 62 is in opposition to the porous semiconductor fine particulate layer 22 of a photoelectrode 2.

Note that adjacent counter electrodes 6 are disposed such as to be electrically insulated from one another. This electrical insulation may be achieved, for example, through partitions 8 that are present in the gaps between adjacent counter electrodes 6, but is not specifically limited to being achieved in this manner.

The second substrate 5 may be the same type of substrate as the first substrate 1, or may be a substrate that is not transparent such as a foil or plate of titanium, SUS (stainless steel), aluminum, or the like, and that is not corroded by other solar cell members. Of these substrates, it is preferable that a resin film is used to form the second substrate 5 for the same reasons as for the first substrate 1.

The same type of conductive layer as for the photoelectrode conductive layer 21 may be used as the counter electrode conductive layer 61.

The catalyst layer 62 is not specifically limited and may be any catalyst layer containing a component that can function as a catalyst such as a conductive polymer, a carbon nanostructure, precious metal particles, or a mixture of a carbon nanostructure and precious metal particles.

Examples of conductive polymers that may be used include polythiophenes such as poly(thiophene-2,5-diyl), poly (3-butylthiophene-2,5-diyl), poly (3-hexylthiophene-2,5-diyl), and poly(2,3-dihydrothieno-[3,4-b]-1,4-dioxine) (PEDOT); polyacetylene and derivatives thereof; polyaniline and derivatives thereof; polypyrrole and derivatives thereof; and polyphenylene vinylenes such as poly(p-xylene tetrahydrothiophenium chloride), poly[(2-methoxy-5-(2'-ethylhexyloxy))-1,4-phenylenevinylene], poly[(2-methoxy-5-(3',7'-dimethyloctyloxy)-1,4-phenylenevinylene)], and poly[2-(2',5'-bis(2"-ethylhexyloxy)phenyl)-1,4-phenylenevinylene].

Examples of carbon nanostructures that may be used include natural graphite, activated carbon, artificial graphite, graphene, carbon nanotubes, and carbon nanobuds.

Any precious metal particles that have a catalytic effect may be used without any specific limitations. Commonly known precious metal particles such as platinum metal, palladium metal, or ruthenium metal may be selected for use as appropriate.

The catalyst layer may be formed by a commonly known method that is selected as appropriate without any specific limitations. For example, the catalyst layer may be formed by applying or spraying, onto a conductive film, a mixture that is obtained by dissolving or dispersing a conductive polymer, a carbon nanostructure, precious metal particles, or both a carbon nanostructure and precious metal particles in an appropriate solvent, and then drying the solvent of the mixture. In the case of a carbon nanostructure or precious metal particles, the mixture may further contain a binder. The binder is preferably a polymer that includes a functional group such as a hydroxy group, a carboxyl group, a sulfonyl group, or a phosphate group, a sodium salt of these functional groups, or the like from a viewpoint of carbon nanostructure dispersibility and close adherence with a substrate.

The catalyst layer may contain carbon nanotubes having an average diameter (Av) and a diameter standard deviation ($\sigma$) that satisfy $0.60 > 3\sigma/Av > 0.20$ (hereinafter also referred to as formula (A)). (Hereinafter, these carbon nanotubes are also referred to as "prescribed carbon nanotubes".) It should be noted that the term "prescribed carbon nanotubes" is used herein as a general term for collectively referring to specific carbon nanotubes composing the "prescribed carbon nanotubes" and the term "diameter" is used herein to refer to the external diameter of the specific carbon nanotubes.

The average diameter (Av) and the diameter standard deviation ($\sigma$) of the prescribed carbon nanotubes are respectively a sample average value and a sample standard deviation. These values are determined as an average value and a standard deviation when the diameters of 100 randomly selected carbon nanotubes are measured by observation under a transmission electron microscope. The term "$3\sigma$" in formula (A) is the obtained standard deviation ($\sigma$) multiplied by 3.

A counter electrode having excellent catalytic activity can be obtained through use of the prescribed carbon nanotubes. From a viewpoint of improving characteristics of the obtained counter electrode, it is preferable that $0.60 > 3\sigma/Av > 0.25$, and more preferable that $0.60 > 3\sigma/Av > 0.50$.

$3\sigma/Av$ expresses the diameter distribution of the prescribed carbon nanotubes and a larger value for $3\sigma/Av$ indicates a wider diameter distribution. The diameter distribution preferably takes a normal distribution. In this situation, the diameter distribution can be obtained by measuring the diameters of 100 randomly selected carbon nanotubes that can be observed using a transmission electron microscope, using the results to plot the obtained data with diameter on the horizontal axis and probability density on the vertical axis, and then making a Gaussian approximation. Although a large $3\sigma/Av$ value can be obtained by combining a plurality of types of carbon nanotubes obtained by different production methods, for example, it is difficult to obtain a normal distribution for the diameter distribution in such a situation. The prescribed carbon nanotubes may be a single type of carbon nanotubes or carbon nanotubes obtained by blending a single type of carbon nanotubes with an amount of other carbon nanotubes that does not affect the diameter distribution of the single type of carbon nanotubes.

The prescribed carbon nanotubes may be obtained by a commonly known method. For example, the prescribed carbon nanotubes may be obtained by a method (super growth method) in which, during synthesis of carbon nanotubes through chemical vapor deposition (CVD) by supplying a feedstock compound and a carrier gas onto a substrate (hereinafter also referred to as a "substrate for CNT production") having a catalyst layer for carbon nanotube production (hereinafter also referred to as a "catalyst layer for CNT production") at the surface thereof, a trace amount of an oxidizing agent is provided in the system to dramatically improve the catalytic activity of the catalyst layer for CNT production (for example, WO 2006/011655 A1). Hereinafter, carbon nanotubes produced by the super growth method are also referred to as SGCNTs.

A counter electrode including a catalyst layer having the prescribed carbon nanotubes as a constituent material can be produced by, for example, preparing a dispersion liquid containing the prescribed carbon nanotubes, applying the dispersion liquid onto a substrate, and drying the resultant applied film to form a catalyst layer.

The partitions 8 of the solar cell module 100 are disposed between the first base plate 3 and the second base plate 7 and surround each of the electrolyte layers 4 and the cell connectors 9. In other words, spaces for the electrolyte layers 4 and spaces for the cell connectors 9 are defined by the first base plate 3, the second base plate 7, and the partitions 8.

Specifically, in FIG. 2, at one side (left side in FIG. 2) of each cell in the width direction thereof, a partition 8 is disposed between the photoelectrode conductive layer 21 of the photoelectrode 2 of the first base plate 3 and the second substrate 5 of the second base plate 7 and, at the other side (right side in FIG. 2) of each cell in the width direction thereof, a partition 8 is disposed between the photoelectrode conductive layer 21 of the photoelectrode 2 of the first base plate 3 and the counter electrode conductive layer 61 (part positioned further to the other side in the width direction than a part where the catalyst layer 62 is formed) of the counter electrode 6 of the second base plate 7. The electrolyte layers 4 and the cell connectors 9 are disposed alternately between the partitions 8.

No specific limitations are placed on the partitions 8 so long as they can adhere the first base plate 3 and the second base plate 7 and can seal each of the electrolyte layers 4. It is preferable that the partitions 8 have excellent adhesiveness with the base plates, electrolyte resistance (chemical resistance), and durability under high temperature and high humidity (wet heat resistance). Examples of partition materials that may be used to form such partitions 8 include non-conductive thermoplastic resins, thermosetting resins, and active radiation (light, electron beam) curable resins. More specific examples include (meth)acrylic resins, fluororesins, silicone resins, olefinic resins, and polyamide resins. In the present specification, "(meth)acryl" is used to indicate "acryl" or "methacryl". Of these materials, a photocurable acrylic resin is preferable from a viewpoint of ease of handling.

Note that from a viewpoint of ease of production, it is of course possible to form the partitions 8 using films obtained by shaping various resins such as described above into a sheet-shaped form.

<Functional layer>

Each electrolyte layer 4 serving as a functional layer in the solar cell module 100 is disposed in a space surrounded by a porous semiconductor fine particulate layer 22 of a photoelectrode 2, a catalyst layer 62 of a counter electrode 6, and partitions 8. The electrolyte layer 4 may be formed using any electrolyte solution, gel electrolyte, or solid electrolyte that can be used in a dye-sensitized solar cell without any specific limitations.

The cell connectors 9 of the solar cell module 100 electrically connect adjacent cells in series. Specifically, each of the cell connectors 9 electrically connects the photoelectrode conductive layer 21 of the photoelectrode 2 in a cell positioned on the right side in FIG. 2 to the counter electrode conductive layer 61 of the counter electrode 6 in a cell positioned on the left side in FIG. 2.

<Cell connectors>

Each of the cell connectors 9 in the solar cell module 100 includes wiring 91 that is formed on the photoelectrode conductive layer 21 of the photoelectrode 2 and is separated from the porous semiconductor fine particulate layer 22, and a conductive resin composition 92 that is used to fill a space surrounded by the first base plate 3, the second base plate 7, and partitions 8. Note that although each of the cell connectors 9 in the solar cell module 100 illustrated in FIG. 2 is formed using wiring 91 and a conductive resin composition 92, a cell connector in the presently disclosed solar cell module may be formed using just a conductive resin composition. Also, wiring may be formed on the counter electrode conductive layer 61 of the counter electrode 6.

Wiring made from a material having conductivity such as a metal or a metal oxide may be used as the wiring 91 without any specific limitations. In particular, it is preferable to use metal wiring such as copper wiring, gold wiring, silver wiring, or aluminum wiring for the wiring 91 from a viewpoint of lowering resistance of the cell connectors 9 and increasing photoelectric conversion efficiency of the dye-sensitized solar cell module. The wiring 91 may be formed on the photoelectrode conductive layer 21 by a known formation method such as sputtering or screen printing.

The conductive resin composition 92 is preferably a composition that contains a resin and conductive particles, but is not specifically limited thereto. Examples of the resin of the conductive resin composition 92 include, but are not specifically limited to, (meth)acrylic resins; epoxy resins such as bisphenol-type epoxy resins, novolac-type epoxy resins, cyclic epoxy resins, and alicyclic epoxy resins; and silicone resins. Any curing agent such as a radical initiator, a cationic curing agent, or an anionic curing agent may be used in the resin. The form of polymerization of the resin is not specifically limited and may be addition polymerization, ring-opening polymerization, or the like. Moreover, a resin used as a partition material and a resin of the conductive resin composition 92 may be the same type or different types of resin.

Examples of the conductive particles of the conductive resin composition 92 include, but are not specifically limited to, particles of metals such as Ag, Au, Cu, Al, In, Sn, Bi, and Pb and alloys containing any of these metals, and also oxides thereof; conductive carbon particles; and particles obtained by coating the surfaces of organic compound particles such as resin particles or inorganic compound particles with a conductive substance such as a metal (for example, Ag, Au, or Cu) or an oxide of such metals (for example, Au/Ni alloy coated particles).

The average particle diameter of the conductive particles is preferably at least 0.5 $\mu$m and not more than 30 $\mu$m. The percentage content of the conductive particles is preferably at least 0.1 volume% and not more than 90 volume%.

The cell connector 9 in which the conductive resin composition 92 described above is used may be formed, for example, by loading an uncured conductive resin composition containing an uncured resin and conductive particles at a position where the cell connector 9 is to be formed and then curing the uncured conductive resin composition that has been loaded, but is not specifically limited to being formed in this manner.

<Lead-out electrodes>

The first lead-out electrode 11A and the second lead-out electrode 11B that are respectively connected to a photoelectrode 2 and a counter electrode 6 are not specifically limited and may each include a conductor that is formed from a typical conductive material. The conductor may be a conductor formed from a metal material selected from the group consisting of copper, aluminum, nickel, and iron, or an alloy material including any of these metal materials. Of these examples, an electrode having copper as a conductor or an electrode having stainless steel as a substrate is preferable.

A thinner conductor is preferable because this reduces the size of a step with the surroundings when sealed by the barrier packaging materials and improves sealing. Moreover, it is preferable that strength that is not problematic for use as a lead-out electrode is maintained. Specifically, the thickness of the conductor is preferably at least 0.001 mm and not more than 0.5 mm.

Note that a product obtained by coating part of the conductor described above with any of the conductive materials that may be used as a material forming the first and second electrical connectors 12A and 12B may optionally be used as a lead-out electrode. In such a situation, it is necessary for the conductor of the lead-out electrode not to be coated at the seal 14 (described in detail below) in order to ensure tight sealing at the seal 14.

The first electrical connector 12A that connects a photoelectrode conductive layer 21 of a photoelectrode 2 with the first lead-out electrode 11A and the second electrical connector 12B that connects a counter electrode conductive layer 61 of a counter electrode 6 with the second lead-out electrode 11B each include conductive pressure-sensitive adhesive. The first and second electrical connectors 12A and 12B are preferably formed from a conductive resin composition or solder from a viewpoint of increasing photoelectric conversion efficiency by lowering resistance. The "conductive resin composition" used to form the first electrical connector 12A and the second electrical connector 12B may contain any material that is typically referred to as a pressure-sensitive adhesive so long as it is a material having adhesiveness and conductivity. The term "pressure-sensitive adhesive" refers to a material that, without the use of water, solvent, heat, or the like, can cause adhesion targets to adhere to one another at room temperature in a short time through application of slight pressure.

Moreover, a known composition that contains a material having conductivity such as a metal, a metal oxide, or a conductive carbon material and any resin may be used as the conductive resin composition in the same way as the previously described conductive resin composition 92. Formation of the first and second electrical connectors using a conductive pressure-sensitive adhesive is preferable from a viewpoint of improving production efficiency. A conductive tape product or the like in which a conductor and a conductive pressure-sensitive adhesive are unified can suitably be used.

Solder that contains tin, silver, copper, bismuth, lead, a flux component, or the like may be used as the solder. The solder is preferably solder that can be formed at a temperature that does not affect elements or substrates.

In production, the conductor of the first lead-out electrode 11A and/or the second lead-out electrode 11B may undergo a roughening treatment step or an oxidation treatment step that is performed with respect to a region that may come into contact with a cured crosslinkable adhesive composition 15 (hereinafter also referred to simply as "crosslinkable adhesive 15") to form the seal 14. When a region of the conductor that may come into contact with the crosslinkable adhesive 15 is roughened or includes an oxide coating, adhesion with the crosslinkable adhesive composition prior to curing is strengthened, and tight sealing at the seal 14 is improved.

The conductor of the first lead-out electrode 11A and/or the conductor of the second lead-out electrode 11B preferably has a surface roughness of at least 0.005 $\mu$m and not more than 0.5 $\mu$m in at least part of the region that may come into contact with the crosslinkable adhesive 15 to form the seal 14. More preferably, each of the conductors has a surface roughness that is at least the lower limit set forth above over the entirety of the region that may come into contact with the crosslinkable adhesive 15 to form the seal 14. When the surface roughness of each of the conductors in at least part of a region that is in contact with the crosslinkable adhesive 15 is at least the lower limit set forth above, each of the lead-out electrodes can be strongly held at the seal 14, and efficiency retention of the solar cell module 100 can be further improved. Furthermore, when the surface roughness of each of the conductors is not more than the upper limit set forth above, the crosslinkable adhesive 15 can sufficiently penetrate irregularities in the surface of the conductor, the lead-out electrodes can be strongly held at the seal 14, and efficiency retention of the solar cell module 100 can be further improved.

Note that although it is not illustrated in FIG. 2, the first electrical connector 12A and the second electrical connector 12B may each be connected to a photoelectrode 2 or counter electrode 6 via current collector wiring formed in the same manner as the wiring 91.

<Seal>

The seal 14 is sealed by the cured crosslinkable adhesive 15. Specifically, gaps between the conductors of the first and second lead-out electrodes 11A and 11B and the barrier packaging materials 13A and 13B at the seal 14 are filled with a cured product of a crosslinkable adhesive composition as illustrated in FIG. 3. Moreover, a gap between the barrier packaging materials 13A and 13B at the seal 14 may also be filled by a cured product of a crosslinkable adhesive composition as illustrated in FIG. 2. The cured crosslinkable adhesive 15 that seals the seal 14 preferably has fluidity prior to curing. In other words, the adhesive is preferably in a state that displays fluidity, such as a liquid state or a gel state, prior to curing. Accordingly, when the crosslinkable adhesive is provided at the seal 14 by a typical method such as application and is then cured, close adherence between the cured crosslinkable adhesive 15 and the barrier packaging materials 13A and 13B can be improved.

The first lead-out electrode 11A and the second lead-out electrode 11B illustrated in FIG. 2 do not have a coating and the respective conductors thereof are in an exposed state at the surface. However, as previously described, even when the lead-out electrodes each have a coating, it is necessary for gaps between the conductors and the barrier packaging materials at the seal 14 to be filled with the cured crosslinkable adhesive 15. This can improve tight sealing at the seal 14 and improve efficiency retention of the solar cell module 100.

Examples of crosslinkable adhesive compositions that may be used include, but are not specifically limited to, photocurable resin compositions and thermosetting resin compositions. Of these compositions, photocurable resin compositions are preferable as the crosslinkable adhesive composition from a viewpoint of increasing hardness and durability of the seal. When the crosslinkable adhesive composition is photocurable, degradation due to heating during production can be prevented, particularly in production of an organic solar cell, and electrical characteristics of the solar cell module can be improved. Moreover, it is expected that a solar cell module having good production efficiency will be obtained because a photocurable resin can be cured in a short time.

Examples of photocurable resin compositions that may be used include ultraviolet curable resin compositions and visible light curable resin compositions, with ultraviolet curable resin compositions being preferable. Specific examples of ultraviolet curable resin compositions that may be used include (meth)acrylic resin compositions, epoxy resin compositions, fluororesin compositions, and olefinic resin compositions. Of these ultraviolet curable resin compositions, the use of an acrylic resin composition, an epoxy resin composition, or a fluororesin composition is preferable. One of these resin compositions may be used individually, or two or more of these resin compositions may be used as a mixture.

Examples of thermosetting resin compositions that may be used include thermosetting resin compositions that can be cured at a temperature that does not cause vaporization of the electrolyte contained in the electrolyte layers 4. More specifically, thermosetting resin compositions having a curing temperature within a range of 60°C to 200°C, preferably within a range of 80°C to 180°C, and more preferably within a range of 100°C to 160°C may be used. Specific examples of thermosetting resin compositions that may be used include (meth)acrylic resin compositions, epoxy resin compositions, fluororesin compositions, silicone resin compositions, olefinic resin compositions, and polyisobutylene resin compositions. One of these resin compositions may be used individually, or two or more of these resin compositions may be used as a mixture.

The thickness of the seal 14 is at least 1 $\mu$m or more, and is 250 $\mu$m or less, and more preferably 200 $\mu$m or less. A smaller thickness is preferable for the seal 14. A smaller seal 14 thickness reduces the sealing cross-sectional area and thereby makes it easier to prevent infiltration of water and the like from the outside. On the other hand, if the seal 14 is too thin, resin may not be able to enter gaps. Also, in a case in which the thickness of the seal 14 is not more than the size of a constituent material or the like (aggregate, filler, etc.) of the resin, stress may act on the barrier packaging materials 13A and 13B. Consequently, the crosslinkable adhesive 15 forming the seal 14 may more easily peel from the barrier packaging materials 13A and 13B or the like. Therefore, the thickness of the seal 14 is preferably selected in accordance with material contained in the crosslinkable adhesive 15. Specifically, when the thickness of the seal 14 is at least the lower limit set forth above, tight sealing of the solar cell module 100 by the seal 14 can be improved. Moreover, when the thickness of the seal 14 is not more than any of the upper limits set forth above, the sealing cross-sectional area, which becomes an infiltration path for moisture or the like, is not excessively wide, and reliability can be maintained.

<Barrier packaging materials>

The barrier packaging materials 13A and 13B provide the solar cell module 100 with durability against high temperature and high humidity environmental conditions to which the solar cell module 100 may be exposed. Accordingly, the barrier packaging materials are preferably packaging that acts as a barrier against gases and water vapor. In FIG. 2, two barrier packaging materials 13A and 13B are illustrated as the barrier packaging material. The barrier packaging material 13A is disposed at the side of the first base plate 3 and the barrier packaging material 13B is disposed at the side of the counter electrodes as clearly illustrated in FIG. 2. However, the barrier packaging material is not limited to being packaging in the form of two sheets that are disposed at the top and bottom of the solar cell module in the thickness direction as illustrated in FIG. 2, and may, for example, alternatively be formed by a tubular film that is open in a depth direction (left/right direction in FIG. 1) of the plurality of cells included in the solar cell module.

No specific limitations are placed on the form in which the first base plate 3 and the second base plate 7 are enclosed by the barrier packaging materials 13A and 13B. For example, the first base plate 3/second base plate 7 and the barrier packaging material 13A/13B may be in a closely adhered state via a crosslinkable adhesive composition. Alternatively, the barrier packaging material 13A/13B may enclose the first base plate 3/second base plate 7 with a space therebetween, and this space may be filled with a filler or the like through which water vapor and gases do not easily pass. More specifically, an adhesive layer (not illustrated) may be present in at least part of a gap between the first substrate 1/second substrate 5 and the barrier packaging material 13A/13B. Tight sealing of the solar cell module can be further improved through the inclusion of the adhesive layer. In particular, in a case in which an adhesive layer is disposed at the side of the first base plate 3 (base plate at photoirradiation side), the presence of the adhesive layer between the barrier packaging material 13A and the first base plate 3 means that an air layer is not interposed between the barrier packaging material 13A and the first substrate 1 of the first base plate 3. An air layer has a significantly different refractive index to the barrier packaging material 13A and the first substrate 1. This results in large differences in refractive index at interfaces of a "barrier packaging material 13A/air layer/first substrate 1" layered structure. When there are large differences in refractive index at the interfaces, the amount of light that is reflected at these interfaces increases and, as a result, the efficiency with which incident light is utilized cannot be sufficiently improved. By filling between the barrier packaging material 13A and the first substrate 1 with an adhesive layer instead of an air layer, refractive index differences can be reduced, and loss due to interface reflection can be reduced. Moreover, suppression of light reflection achieved by providing the adhesive layer can inhibit the occurrence of interference fringes at the solar cell module surface. It is more preferable that a material having a refractive index value that is between the refractive index values of the barrier packaging material 13A and the first substrate 1 is selected as a material forming the adhesive layer. A material such as described above may, for example, be selected from the materials listed as partition materials while taking into account the material of the barrier packaging material 13A and the material of the first substrate 1.

Moreover, particularly in a case in which the solar cell module is a dye-sensitized solar cell module, it is preferable that a material having high light transmittance in an absorption wavelength region of the used dye is selected as the material forming the adhesive layer.

Examples of fillers through which water vapor and gases do not easily pass include liquid and gel paraffin, silicone, phosphoric acid esters, and aliphatic esters.

The water vapor permeability of the barrier packaging materials 13A and 13B in an environment having a temperature of 40°C and a relative humidity of 90% (90% RH) is preferably 0.1 g/m$^2$/day or less, more preferably 0.01 g/m$^2$/day or less, even more preferably 0.0005 g/m$^2$/day or less, and particularly preferably 0.0001 g/m$^2$/day or less.

The total luminous transmittance of the barrier packaging materials 13A and 13B is preferably 50% or more, more preferably 70% or more, and even more preferably 85% or more. The total luminous transmittance can be measured in accordance with JIS K7361-1, for example.

The barrier packaging materials 13A and 13B are preferably each a film that includes a barrier layer having low water vapor and gas permeability on a plastic support. Examples of barrier films having low gas permeability include films obtained through vapor deposition of silicon oxide or aluminum oxide (JP S53-12953 B, JP S58-217344 A), films including an organic-inorganic hybrid coating layer (JP 2000-323273 A, JP 2004-25732 A), films containing an inorganic layered compound (JP 2001-205743 A), films in which inorganic materials are stacked (JP 2003-206361 A, JP 2006-263989 A), films in which organic and inorganic layers are alternately stacked (JP 2007-30387 A; US 6413645 B1; Affinito et al., Thin Solid Films, 1996, pages 290 and 291), and films in which organic and inorganic layers are consecutively stacked (US 2004-46497 A).

(Production method of solar cell module)

The solar cell module 100 having the configuration set forth above can be produced by the following procedure, for example, but is not specifically limited to being produced in this manner. Specifically, a first base plate 3 including photoelectrodes 2 is first produced, and then wiring 91 is formed on the produced first base plate 3. Next, an uncured conductive resin composition 92 is applied at positions overlapping with the wiring 91, and then a partition material is applied such as to sandwich the applied conductive resin composition 92 and surround each photoelectrode conductive layer 21. A constituent component of electrolyte layers 4, such as an electrolyte solution, is then used to fill regions where the partition material has been applied. Thereafter, a second base plate 7 including counter electrodes 6 is overlapped with the first base plate 3. The uncured conductive resin composition 92 is cured to form cell connectors 9 and strongly adhere the first base plate 3 and the second base plate 7 to thereby obtain a pair of electrode base plates.

A first lead-out electrode 11A and a second lead-out electrode 11B are respectively adhered to a photoelectrode 2 and a counter electrode 6 included in the obtained pair of electrode base plates via a conductive adhesive (lead-out electrode attachment step). A crosslinkable adhesive composition is applied to barrier packaging materials 13A and 13B (application step) and then these barrier packaging materials 13A and 13B are used to sandwich the pair of electrode base plates to which the lead-out electrodes have been attached from upper and lower surfaces of the pair of electrode base plates (sandwiching step). Moreover, the barrier packaging materials 13A and 13B and conductors are closely adhered via the crosslinkable adhesive composition while pressing the pair of base plates in a thickness direction via the barrier packaging materials 13A and 13B using a pressing member (pressing close adhesion step) to thereby obtain a solar cell module 100 having the configuration set forth above in which the electrode base plate 3 and the second base plate 7 are packaged by the barrier packaging materials 13A and 13B. The following provides a more detailed description of production from the lead-out electrode attachment step to the pressing close adhesion step.

<Lead-out electrode attachment step>

In the lead-out electrode attachment step, a first lead-out electrode 11A is attached to a photoelectrode 2 included in the pair of electrode base plates and a second lead-out electrode 11B is attached to a counter electrode 6 included in the pair of electrode base plates via a conductive resin composition or solder. The conductive resin composition or solder is a formation material of the first and second electrical connectors. This conductive resin composition or solder is preferably disposed on conductors of the lead-out electrodes in advance. Specifically, the first lead-out electrode and the second lead-out electrode may be formed using electrodes obtained by precoating conductors of lead-out electrodes with a conductive resin composition or solder such as previously described. In this situation, each of the conductors may be attached to a photoelectrode 2 or counter electrode 6 with the conductive resin composition or solder on at least part of the conductor placed in a state in which adhesiveness is displayed thereby through a known method such as heating. Production efficiency of the solar cell module 100 can be improved by using a conductor on which a formation material of an electrical connector has been partially disposed in advance in this manner.

Moreover, in a case in which a lead-out electrode is formed using a conductor that has been precoated with a conductive resin composition or solder, it is preferable that the coating is removed in advance from at least a region that comes into contact with a seal 14, which is a region other than the part that is attached to the photoelectrode 2/counter electrode 6. This can improve tight sealing of the seal.

<Application step>

In the application step, a crosslinkable adhesive composition is applied onto barrier packaging materials 13A and 13B by typical application means that can be used to apply a target having fluidity, such as a dispenser method or a screen printing method. The amount of the crosslinkable adhesive composition that is applied may be set as appropriate in order to achieve good tight sealing of the seal 14, close adherence of the barrier packaging material 13A and the first base plate 3, and close adherence of the barrier packaging material 13B and the second base plate 7. Moreover, it is preferable to set the applied amount such that at least the thickness of the seal 14 is within any of the preferred ranges set forth above.

The viscosity of the crosslinkable adhesive composition is preferably 10 Pa·s or more, and more preferably 40 Pa·s or more, and is preferably 200 Pa·s or less, more preferably 160 Pa·s or less, and even more preferably 100 Pa·s or less. When the viscosity is at least any of the lower limits set forth above, a seal can easily be formed with the desired thickness, tight sealing of the seal can be improved, and good coatability can be obtained. Moreover, when the viscosity is not more than any of the upper limits set forth above, excessive thickening of the seal can be inhibited, and tight sealing of the seal can be improved.

<Sandwiching step>

In the sandwiching step, the barrier packaging materials are positioned with the surfaces onto which the crosslinkable adhesive composition has been applied in the application step facing toward exposed surfaces of the electrode base plate 3 and the second base plate 7 that have been adhered to one another. Two barrier packaging materials 13A and 13B may be positioned at the exposed surface of the electrode base plate 3 and the exposed surface of the second base plate 7, respectively. Alternatively, one barrier packaging material may be folded such as to sandwich the exposed surface of the first base plate 3 and the exposed surface of the second base plate 7 from above and below.

<Pressing close adhesion step>

In the pressing close adhesion step, the conductors of the lead-out electrodes and the barrier packaging materials are closely adhered through the crosslinkable adhesive composition while pressing the pair of base plates including the first base plate 3 and the second base plate 7 and the barrier packaging materials 13 in the thickness direction of the solar cell module 100 using a pressing member. The pressing member is formed from silicone rubber and includes a recess that fits with the above-described pair of base plates in at least a pressed state. More specifically, the pressing member is an elastic body formed from silicone rubber in which a recess that fits with the pair of base plates is formed in a pressed state when pressing of the pair of base plates is performed in this step. The use of an elastic body has an effect of producing a recess and also enables pressing in a closely adhered state even along a step at a location where a partial step arises with the surroundings, such as around the lead-out electrodes, which can inhibit widening of sealing cross-sectional area at such locations. Examples of the elastic body include, but are not specifically limited to, natural rubber, diene rubbers, non-diene rubbers, and thermoplastic elastomers. Of these examples, silicone rubber, which is a non-diene rubber, is used in the method of the present invention, the others are not claimed. In a region of the barrier packaging materials that is adjacent to the pair of base plates, the elastic body is required to have hardness that is at least high enough to cause deformation of the barrier packaging materials in a pressed state. Therefore, the hardness of the elastic body is set as appropriate depending on the material of the barrier packaging materials.

Moreover, the pressing member is preferably a pressing member for which hardness of the elastic body at a part that comes into contact with the region of the barrier packaging material that is adjacent to the pair of base plates is higher than hardness of the elastic body at a part that comes into contact with the pair of base plates. Alternatively, a member that is formed from an elastic body such as described above and already includes a recess that fits with the pair of base plates (i.e., has the recess in a non-pressed state) may preferably be used as the pressing member. When such a pressing member is used in this step, the region of the barrier packaging material that is adjacent to the pair of base plates can be efficiently pressed, and a seal 14 having a high level of tight sealing can be efficiently formed.

EXAMPLES

The following provides a more specific description of the present disclosure based on examples. However, the present disclosure is not limited to the following examples. In the following description, "%" used to express a quantity is by mass, unless otherwise specified.

In the examples and comparative examples, the viscosity of a crosslinkable adhesive, the thickness of a seal, and the efficiency retention of a solar cell module were evaluated by the following methods.

<Viscosity of crosslinkable adhesive composition>

The viscosity of a crosslinkable adhesive composition used in each example or comparative example was measured at 25°C using a cone and plate viscometer (cone angle: 3°; rotation speed: 2.5 rpm).

<Thickness of seal>

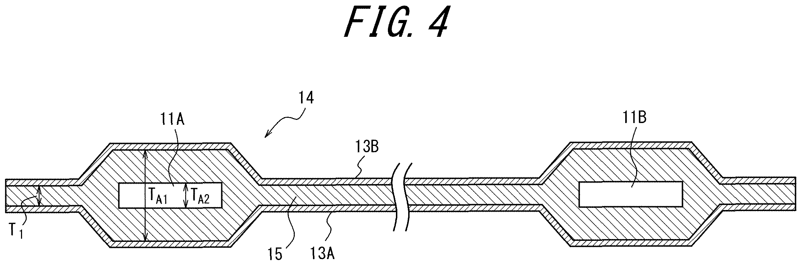

A solar cell module produced in each example or comparative example was cut to obtain a cross-section along a thickness direction of the solar cell module that included a seal of the solar cell module, and the obtained cross-section was polished. The cutting position was set such that copper foils of lead-out electrodes, a layer containing cured crosslinkable adhesive forming the seal, and barrier films serving as a barrier packaging material were exposed at the cross-section. Such a cutting position may, for example, be a cutting position along a line IV-IV in FIG. 1. FIG. 4 is a cross-sectional view for facilitating description of the measurement method of thickness of a seal of a solar cell module. As illustrated in FIG. 4, gaps between a first lead-out electrode 11A or a second lead-out electrode 11B and barrier packaging materials 13A and 13B, and gaps between the barrier packaging materials 13A and 13B at a seal 14 are filled by a cured crosslinkable adhesive 15. Note that conductors of the first lead-out electrode 11A and the second lead-out electrode 11B are not coated at least within the seal 14, and thus the outer surfaces of the conductors correspond to the outer surfaces of the illustrated first lead-out electrode 11A and second lead-out electrode 11B.

As illustrated in FIG. 4, the thickness of the seal 14 is calculated as an average value of thickness $T_1$ ($\mu$m) of a gap between the barrier packaging materials 13A and 13B and a value $T_A$ that is obtained by subtracting thickness $T_{A2}$ ($\mu$m) of the first lead-out electrode 11A (or second lead-out electrode 11B) from thickness $T_{A1}$ ($\mu$m) of a gap between the barrier packaging materials 13A and 13B in a region where the first lead-out electrode 11A (or second lead-out electrode 11B) is enclosed, and then dividing the resultant value by 2. The thicknesses $T_1$, $T_{A1}$, and $T_{A2}$ can be measured through observation of the cross-section under a scanning electron microscope (SEM). $T_1$ and $T_A$ were each measured at four different positions and then an average value was calculated as the thickness of the seal 14.

<Efficiency retention of solar cell module>

A solar cell module produced in each example or comparative example was connected to a SourceMeter (Model 2400 SourceMeter produced by Keithley Instruments, Inc.). A solar simulator (PEC-L11 produced by Peccell Technologies, Inc.) having an AM1.5G filter attached to a 150 W xenon lamp illumination device was used as an illuminant. The illuminant was adjusted to an intensity of 1 sun (approximately 100,000 lux AM1.5G, 100 mWcm$^{-2}$ (Class A of JIS C 8912)) and was used to irradiate the solar cell module. The output current of the solar cell module was measured under 1 sun photoirradiation while changing the bias voltage from 0 V to 0.8 V in units of 0.01 V to acquire a current-voltage characteristic. Measurement was performed in the same manner while stepping the bias voltage from 0.8 V to 0 V in the reverse direction. Average values for the forward and reverse directions were taken as photocurrent data. The initial photoelectric conversion efficiency (%) was calculated from the current-voltage characteristic and photocurrent data obtained in this manner.

Next, the dye-sensitized solar cell module was held for 300 hours in an environment of 65°C and 90% RH, and then a current-voltage characteristic of the solar cell module was measured in the same way as described above. The conversion efficiency was determined in the same way as above, and efficiency retention relative to the initial value was calculated by the following formula.

$$\text{Efficiency retention (\%)} = [\text{Conversion efficiency after holding at } 65°C \text{ and } 90\% \text{ RH}]/[\text{Initial conversion efficiency}] \times 100$$

(Example 1)

<Preparation of dye solution>

A 200 mL volumetric flask was charged with 72 mg of a ruthenium complex dye (N719 produced by Solaronix). Mixing and agitation with 190 mL of dehydrated ethanol was then performed. The volumetric flask was stoppered and then subjected to 60 minutes of agitation through vibration by an ultrasonic cleaner. The solution was held at normal temperature and then dehydrated ethanol was added to adjust the total volume to 200 mL and thereby obtain a dye solution.

<Production of first base plate>

A transparent conductive base plate (sheet resistance: 13 ohm/sq.) obtained by coating a transparent base plate (polyethylene naphthalate film of 200 $\mu$m in thickness) serving as a first substrate with a transparent conductive layer (indium tin oxide (ITO)) serving as a photoelectrode conductive layer was subjected to screen printing to print conductive silver paste (K3105 produced by Pelnox Limited) serving as wiring (current collector wiring) at intervals in accordance with photoelectrode cell width. Heating and drying were then performed for 15 minutes in a 150°C hot air circulation oven to produce wiring. The transparent conductive base plate including the obtained wiring was set in a coater with the wiring formation surface thereof facing upward, and a wire bar was used to apply an ORGATIX PC-600 solution (produced by Matsumoto Fine Chemical Co., Ltd.) that had been diluted to 1.6% at a sweep rate of 10 mm/s. The obtained coating was dried for 10 minutes at room temperature and was then further heated and dried for 10 minutes at 150°C to produce an undercoat layer on the transparent conductive base plate.

Laser processing was performed with respect to the undercoat layer formation surface of the transparent conductive base plate at intervals in accordance with the photoelectrode cell width to form insulated wiring.

In addition, openings (length: 60 mm; width: 5 mm) for porous semiconductor fine particulate layer formation were punched in a mask film obtained through two-stage stacking of protective films each having a pressure-sensitive adhesive layer coated on polyester film (lower stage: PC-542PA produced by Fujimori Kogyo Co., Ltd.; upper stage: NBO-0424 produced by Fujimori Kogyo Co., Ltd.). The processed mask film was pasted to the current collector wiring formation surface of the transparent conductive base plate on which the undercoat layer had been formed such that air bubbles did not enter therebetween. Note that the aim of the first layer of the mask film was to prevent adhesion of dye at unnecessary locations and the aim of the second layer of the mask film was to prevent adhesion of porous semiconductor fine particles at unnecessary locations.

A high-pressure mercury lamp (rated lamp power: 400 W) illuminant was positioned at a distance of 10 cm from the mask pasting surface. Straight after 1 minute of irradiation with electromagnetic waves, titanium oxide paste (PECC-C01-06 produced by Peccell Technologies, Inc.) was applied using a Baker-type applicator. The paste was dried for 10 minutes at normal temperature and then the upper protective film (NBO-0424 produced by Fujimori Kogyo Co., Ltd.) of the mask film was removed by peeling. Heating and drying were performed for 5 minutes in a 150°C hot air circulation oven to form porous semiconductor fine particulate layers (length: 60 mm; width: 5 mm).

Thereafter, the transparent conductive base plate on which the porous semiconductor fine particulate layers (length: 60 mm; width: 5 mm) had been formed was immersed in the prepared dye solution (40°C) and adsorption of dye was carried out under gentle agitation. After 90 minutes had passed, the titanium oxide films to which the dye had adsorbed were removed from the dye adsorption vessel, were washed with ethanol, and were dried, and then remaining mask film was removed by peeling to thereby produce photoelectrodes.

<Production of second base plate>

The conductive surface of a transparent conductive base plate (sheet resistance: 13 ohm/sq.) obtained by coating a transparent base plate (polyethylene naphthalate film of 200 $\mu$m in thickness) serving as a second substrate with a transparent conductive layer (indium tin oxide (ITO)) serving as a counter electrode conductive layer was subjected to laser processing at intervals in accordance with platinum film pattern width to form insulated wiring. Next, a metal mask in which openings (length: 60 mm; width: 5 mm) had been punched was overlapped, and sputtering was performed to form a platinum film pattern (catalyst layers) and thereby obtain a second base plate having light transmittance of approximately 72% in catalyst layer formation parts thereof. Note that the porous semiconductor fine particulate layers and the catalyst layers had structures that matched when the first base plate and the second base plate were overlapped with the conductive surfaces thereof facing one another.

<Production of dye-sensitized solar cell module>

A conductive resin composition was prepared by adding Micropearl AU (particle diameter: 8 $\mu$m) produced by Sekisui Jushi Corporation to TB3035B (produced by ThreeBond Holdings Co., Ltd.) as an acrylic resin serving as a resin material of the conductive resin composition such that the amount of Micropearl AU was 3 mass%, and then performing uniform mixing using a planetary centrifugal mixer.

The second base plate was secured to a suction plate made from aluminum using a vacuum pump with the catalyst layer formation surface of the second base plate as a front surface. Next, a dispensing device was used to apply the conductive resin composition between the catalyst layers as lines at positions that, when in opposition with the first base plate, overlapped with the wiring between the photoelectrode cells, and to apply a liquid ultraviolet curable sealant "TB3035B" (produced by ThreeBond Holdings Co., Ltd.; absorption wavelength: 200 nm to 420 nm; viscosity: 51 Pa·s) as a partition material at the periphery of the catalyst layers such as to sandwich these lines therebetween. Thereafter, a specific amount of electrolyte solution was applied to catalyst layer parts and then an automatic pasting apparatus was used to perform stacking in a reduced pressure environment such as to obtain a structure in which rectangular catalyst layers and similarly shaped porous semiconductor fine particulate layers faced one another. Photoirradiation with a metal halide lamp was performed from the first base plate side and then photoirradiation was also performed from the second base plate side. Thereafter, connected bodies including a plurality of cells were each cut out from the pasted base plates. Conductive copper foil tape (CU7636D produced by Sony Chemical and Information Device Corporation; thickness of copper foil (conductor): 35 $\mu$m) for forming lead-out electrodes was attached to wiring disposed at both ends (lead-out electrode parts) of the connected body. The surface of the conductive copper foil tape used in this example was precoated with a conductive pressure-sensitive adhesive formed from a conductive acrylic resin. Consequently, the electrical connectors interposed between the photoelectrode/counter electrode and lead-out electrodes were each formed by the conductive pressure-sensitive adhesive coated on the conductors forming the lead-out electrodes. Moreover, the conductive copper foil tape used to form each of the lead-out electrodes was tape from which the pressure-sensitive adhesive coating had been removed prior to attachment with the exception of coating in a region that was to be used for attachment to the photoelectrode/counter electrode (i.e., a region for forming an electrical connector). The surface roughness Ra of the section where the coating had been removed was 0.035 $\mu$m. Moreover, the surface of copper foil tape at the section where the conductive coating had been removed was in a state including an oxide coating formed through natural oxidation under exposure to air.

Next, two barrier films (Ultra-High Barrier Film produced by Neo Seeds Co., Ltd.; water vapor permeability: 0.00005 g/m$^2$/day) serving as a barrier packaging material that were each larger than the cut-out connected body including a plurality of cells were prepared. One of the barrier films was secured to an aluminum suction plate using a vacuum pump, and the connected body was stacked thereon with the conductive copper foil tape extending outside of the barrier film. A liquid ultraviolet curable crosslinkable adhesive composition (TB3035B produced by ThreeBond Holdings Co., Ltd.; acrylic resin) serving as a crosslinkable adhesive composition for forming a seal was applied onto the entire surface of the connected body, the barrier film at the periphery of the connected body, inclusive of a front surface of the conductive copper foil tape (coating removed), and a rear surface of the conductive copper foil tape at the periphery. The viscosity of the ultraviolet curable crosslinkable adhesive composition as measured by the previously described method at 25°C was 51 Pa·s.

The connected body with the barrier film was placed on a lower member of a pair of upper and lower pressing members that was a jig having a protruding surface made of a rubber material that protruded at sections coming into contact with around the periphery of the first base plate and the second base plate. Next, the other barrier film was stacked from above and was pressed from above in the thickness direction using a jig having a protruding surface made from a silicone rubber material at a section coming into contact with around the periphery of the base plates and made from a sponge silicone rubber material having lower hardness than the aforementioned material at a section coming into contact with the base plates, and photoirradiation was carried from both sides to thereby package the connected body of a plurality of cells using the barrier films.

(Example 2) (not claimed)

A dye-sensitized solar cell module was produced and various measurements and evaluations were carried out in the same way as in Example 1 with the exception that the lead-out electrodes were formed using copper foil having a thickness of 35 $\mu$m and a surface roughness Ra of 0.3 $\mu$m instead of conductive copper foil tape, and conductive paste DOTITE® (DOTITE is a registered trademark in Japan, other countries, or both; DOTITE D-362 produced by Fujikura Kasei Co., Ltd.) was used as a conductive resin composition forming the electrical connectors and was connected to current collector wiring of the lead-out electrodes. The results are shown in Table 1.

(Example 3)

A dye-sensitized solar cell module was produced, and various measurements and evaluations were carried out in the same way as in Example 1 with the exception that a liquid ultraviolet curable crosslinkable adhesive composition "TB3118" (produced by ThreeBond Holdings Co., Ltd.; absorption wavelength: 200 nm to 350 nm) having a viscosity of 86 Pa·s at 25°C as measured by the previously described method was used as a crosslinkable adhesive composition forming the seal instead of the liquid ultraviolet curable crosslinkable adhesive composition "TB3035B" (produced by ThreeBond Holdings Co., Ltd.). The results are shown in Table 1.

(Example 4)

A dye-sensitized solar cell module was produced, and various measurements and evaluations were carried out in the same way as in Example 1 with the exception that a liquid ultraviolet curable crosslinkable adhesive composition "Nichiban UM" (produced by Nichiban Co., Ltd.; absorption wavelength: 200 nm to 420 nm) having a viscosity of 150 Pa·s at 25°C as measured by the previously described method was used as a crosslinkable adhesive composition forming the seal instead of the liquid ultraviolet curable crosslinkable adhesive composition "TB3035B" (produced by ThreeBond Holdings Co., Ltd.). The results are shown in Table 1.

(Comparative Example 1)

A dye-sensitized solar cell module was produced, and various measurements and evaluations were carried out in the same way as in Example 1 with the exception that conductive copper foil tape in a state in which a coating of conductive pressure-sensitive adhesive had not been removed was used as the lead-out electrodes. The results are shown in Table 1.

(Comparative Example 2)

Thermal bonding film (produced by DuPont-Mitsui Polychemicals Co., Ltd.; product name: Himilan® (Himilan is a registered trademark in Japan, other countries, or both); brand: 1652) having a thickness of 25 μm was used to form the seal instead of the liquid crosslinkable adhesive composition. In formation of the seal during production of the dye-sensitized solar cell module, thermal bonding films were positioned above and below the copper foil tapes such as to sandwich the tapes. Moreover, the thermal bonding films were sandwiched from above and below by the barrier films and were heated to a temperature at least as high as the thermal bonding temperature thereof. With the exception of the above points, a dye-sensitized solar cell module was produced, and various measurements and evaluations were carried out in the same way as in Example 1. The results are shown in Table 1.

(Comparative Example 3)

A dye-sensitized solar cell module was produced, and various measurements and evaluations were carried out in the same way as in Comparative Example 2 with the exception that thermal bonding film (produced by DuPont-Mitsui Polychemicals Co., Ltd.; product name: Himilan®; brand: 1652) having a thickness of 50 μm was used to form the seal instead of the liquid crosslinkable adhesive composition. The results are shown in Table 1.

Table 1

| | Seal | | | | Lead-out electrodes | | | Electrical connectors | Evaluation |
| | Filling material of conductor-barrier packaging material gap | | Presence of coating on lead-out electrodes | Thickness [μm] | Conductive material | | | Conductive resin composition | |
| | Type | Viscosity [Pa.s] | | | Type | Thickness [μm] | Surface roughness Ra [μm] | Type | Efficiency retention [%] |
|---|---|---|---|---|---|---|---|---|---|
| Example 1 | Ultraviolet curabb crosslinkable adhesive | 51 | Removed | 52 | Cu | 35 | 0.035 | Conductive pressure-sensitive adhesive | 99 |
| Example 2 | Ultraviolet curabb crosslinkable adhesive | 51 | Removed | 54 | Cu | 35 | 0.3 | Conductive paste | 98 |
| Example 3 | Ultraviolet curabb crosslinkable adhesive | 86 | Removed | 93 | Cu | 35 | 0.035 | Conductive pressure-sensitive adhesive | 98 |
| Example 4 | Ultraviolet curabb crosslinkable adhesive | 150 | Removed | 107 | Cu | 35 | 0.035 | Conductive pressure-sensitive adhesive | 84 |
| Comparative Example 1 | Ultraviolet curabb crosslinkable adhesive | 51 | Present | 74 | Cu | 35 | 0.035 | Conductive pressure-sensitive adhesive | 23 |
| Comparative Example 2 | Thermal bonding film | - | Removed | 22 | Cu | 35 | 0.035 | Conductive pressure-sensitive adhesive | 6 |
| Comparative Example 3 | Thermal bonding film | - | Removed | 44 | Cu | 35 | 0.035 | Conductive pressure-sensitive adhesive | 15 |

Examples 1 to 4 demonstrate that a solar cell module in which a barrier packaging material is sealed by a cured product of a crosslinkable adhesive composition has an excellent photoelectric conversion efficiency retention rate. On the other hand, it can be seen that the photoelectric conversion efficiency retention rate was poor in Comparative Examples 1 to 3 in which gaps between the conductors of the lead-out electrodes and the barrier packaging materials at the seal were not filled with a cured product of a crosslinkable adhesive composition. In particular, in Comparative Example 1 in which the lead-out electrodes were coated by a conductive pressure-sensitive adhesive at the seal, the coating was found to act as a start point for infiltration of moisture into the solar cell module. Moreover, in Comparative Examples 2 and 3 in which a seal was formed with thermal bonding film that did not have fluidity in a pre-curing state interposed between the lead-out electrodes and the barrier packaging materials, gaps were found to form in the seal of the produced solar cell module. These gaps were formed at boundaries between the thermal bonding film and the conductors and at boundaries between the thermal bonding film and the barrier packaging materials.

INDUSTRIAL APPLICABILITY

According to the present disclosure, it is possible to provide a solar cell module that includes a barrier packaging material protecting the solar cell module from the external environment and that has an excellent photoelectric conversion efficiency retention rate.

REFERENCE SIGNS LIST

| | |
|---|---|
| 1 | first substrate |
| 2 | photoelectrode |
| 3 | first base plate |
| 4 | electrolyte layer |
| 5 | second substrate |
| 6 | counter electrode |
| 7 | second base plate |
| 8 | partition |
| 9 | cell connector |
| 11A | first lead-out electrode |
| 11B | second lead-out electrode |
| 12A | first electrical connector |
| 12B | second electrical connector |
| 13A, 13B | barrier packaging material |
| 14 | seal |
| 15 | cured crosslinkable adhesive composition |
| 21 | photoelectrode conductive layer |
| 22 | porous semiconductor fine particulate layer |
| 61 | counter electrode conductive layer |
| 62 | catalyst layer |
| 91 | wiring |
| 92 | conductive resin composition |
| 100 | solar cell module |

Claims

1. A solar cell module (100) comprising:

one or more photoelectric conversion cells in which a first electrode at a side of a first base plate (3) and a second electrode at a side of a second base plate (7) are in opposition via a functional layer;
at least one barrier packaging material (13A, 13B) that is sealed by a seal (14) and encloses the one or more photoelectric conversion cells;
a first lead-out electrode (11A) connected to the first electrode via a first electrical connector (12A); and
a second lead-out electrode (11B) connected to the second electrode via a second electrical connector (12B), wherein

the functional layer is an electrolyte layer (4) and the solar cell module (100) is a dye-sensitized solar cell module, the first lead-out electrode (11A) and the second lead-out electrode (11B) each include a conductor, and whrerein the at least one seal (14) extends from the solar cell module (100) to outside of the module (100), wherein either or both of the first lead-out electrode (11A) and the second lead-out electrode (11B) extend through said seal (14) from the solar cell module (100) to outside of the solar cell module (100), and at which a gap between each of the conductors and the barrier packaging material is filled by a cured product of a crosslinkable adhesive composition (15),

**characterized in that** each of the first electrical connector (12A) and the second electrical connector (12B) includes conductive pressure-sensitive adhesive, and

the at least one seal (14) has a thickness of at least 1 $\mu$m and not more than 250 $\mu$m.

2. The solar cell module (100) according to claim 1, wherein the first base plate (3) and the second base plate (7) each include a resin film.

3. The solar cell module (100) according to claim 1 or 2, wherein the first electrical connector (12A) and the second electrical connector (12B) each contain a conductive resin (92).

4. The solar cell module (100) according to claim 1 or 2, wherein the first electrical connector (11A) and the second electrical connector (11B) each contain solder.

5. The solar cell module (100) according to any one of claims 1 to 4, wherein the crosslinkable adhesive composition (15) is a photocurable resin composition.

6. The solar cell module (100) according to any one of claims 1 to 6, further comprising an adhesive layer disposed in at least part of a gap between the barrier packaging material and either or both of the first base plate (3) and the second base plate (7).

7. A method of producing the solar cell module (100) according to any one of claims 1 to 6, comprising:

an application step of applying the crosslinkable adhesive composition (15) onto the barrier packaging material; a sandwiching step of using the barrier packing material to sandwich a pair of base plates including the first base plate (3) that includes the first lead-out electrode (11A) and the second base plate (7) that includes the second lead-out electrode (11B) from upper and lower surfaces of the pair of base plates; and a pressing close adhesion step of closely adhering the barrier packing material to the conductor of the first lead-out electrode (11A) and the conductor of the second lead-out electrode (11B) via the crosslinkable adhesive composition (15) while pressing the pair of base plates in a thickness direction via the barrier packaging material using a pressing member, wherein the pressing member is formed of silicone rubber and includes a recess that fits with the pair of base plates in at least a pressed state.

8. The method according to claim 7, wherein the pressing member has higher hardness in a region that does not come into contact with the pair of base plates than in a region that does come into contact with the pair of base plates.

9. The method according to claim 8, wherein the pressing member includes a recess that fits with the pair of base plates in a non-pressed state.

10. The method according to any one of claims 7 to 9, wherein the crosslinkable adhesive composition (15) has a viscosity of at least 10 Pa·s and not more than 200 Pa·s.

11. The method according to any one of claims 7 to 10, wherein a first lead-out electrode (11A) on which a formation material of the first electrical connector (12A) is partially disposed in advance and a second lead-out electrode (11B) on which a formation material of the second electrical connector (12B) is partially disposed in advance are used.

**Patentansprüche**

1. Ein Solarzellenmodul (100), das Folgendes umfasst:

eine oder mehrere photoelektrische Umwandlungszellen, bei denen sich eine erste Elektrode auf einer Seite einer ersten Grundplatte (3) und eine zweite Elektrode auf einer Seite einer zweiten Grundplatte (7) über eine Funktionsschicht gegenüberstehen;

mindestens ein Barriereverpackungsmaterial (13A, 13B), das durch eine Dichtung (14) versiegelt ist und die eine oder mehrere photoelektrische Umwandlungszellen umschließt;

eine erste Ableitelektrode (11A), die über einen ersten elektrischen Verbinder (12A) mit der ersten Elektrode verbunden ist; und

eine zweite Ableitelektrode (11B), die mit der zweiten Elektrode über einen zweiten elektrischen Verbinder (12B) verbunden ist, wobei

die Funktionsschicht eine Elektrolytschicht (4) ist und das Solarzellenmodul (100) ein Farbstoffsolarzellenmodul ist,

die erste Ableitelektrode (11A) und die zweite Ableitelektrode (11B) jeweils einen Leiter enthalten, und

wobei sich die mindestens eine Dichtung (14) von dem Solarzellenmodul (100) zur Außenseite des Solarzellenmoduls (100) erstreckt, und wobei ein Spalt zwischen jedem der Leiter und dem Barriereverpackungsmaterial durch ein gehärtetes Produkt einer vernetzbaren Klebstoffzusammensetzung (15) gefüllt ist,

**dadurch gekennzeichnet, dass** sowohl der erste elektrische Verbinder (12A) als auch der zweite elektrische Verbinder (12B) einen leitfähigen druckempfindlichen Klebstoff enthält, und

die mindestens eine Dichtung (14) eine Dicke von mindestens $1\mu$ m und nicht mehr als $250\mu$ m hat.

2. Solarzellenmodul (100) nach Anspruch 1, wobei die erste Grundplatte (3) und die zweite Grundplatte (7) jeweils einen Harzfilm enthalten.

3. Solarzellenmodul (100) nach Anspruch 1 oder 2, wobei der erste elektrische Verbinder (12A) und der zweite elektrische Verbinder (12B) jeweils ein leitfähiges Harz (92) enthalten.

4. Solarzellenmodul (100) nach Anspruch 1 oder 2, wobei der erste elektrische Verbinder (11A) und der zweite elektrische Verbinder (11B) jeweils Lot enthalten.

5. Solarzellenmodul (100) nach einem der Ansprüche 1 bis 4, wobei die vernetzbare Klebstoffzusammensetzung (15) eine photohärtbare Harzzusammensetzung ist.

6. Solarzellenmodul (100) nach einem der Ansprüche 1 bis 6, mit einer Klebeschicht, die zumindest in einem Teil eines Spalts zwischen dem Barriereverpackungsmaterial und der ersten Grundplatte (3) oder der zweiten Grundplatte (7), oder beiden angeordnet ist.

7. Verfahren zur Herstellung des Solarzellenmoduls (100) nach einem der Ansprüche 1 bis 6, umfassend:

einen Applikationsschritt, bei dem die vernetzbare Klebstoffzusammensetzung (15) auf das Barriereverpackungsmaterial aufgetragen wird;

einen Sandwich-Schritt, bei dem das Barriereverpackungsmaterial verwendet wird, um ein Paar von Grundplatten, das die erste Grundplatte (3), die die erste Aleitelektrode (11A) enthält, und die zweite Grundplatte (7), die die zweite Ableitelektrode (11B) enthält, umfasst, von oberen und unteren Oberflächen des Paars von Grundplatten sandwichartig zu verbinden; und

einen Schritt des engen Anpressens des Barriereverpackungsmaterials an den Leiter der ersten Ableitelektrode (11A) und den Leiter der zweiten Ableitelektrode (11B) über die vernetzbare Klebstoffzusammensetzung (15), während das Paar von Basisplatten in einer Dickenrichtung über das Barriereverpackungsmaterial unter Verwendung eines Presselements gepresst wird, wobei

das Druckelement aus Silikongummi besteht und eine Aussparung aufweist, die zumindest in gepresstem Zustand zu dem Paar von Grundplatten passt.

8. Verfahren nach Anspruch 7, wobei das Druckelement in einem Bereich, der nicht in Kontakt mit dem Grundplattenpaar kommt, eine höhere Härte aufweist als in einem Bereich, der in Kontakt mit dem Grundplattenpaar kommt.

9. Verfahren nach Anspruch 8, wobei das Druckelement eine Aussparung aufweist, die im nicht gepressten Zustand zu dem Paar von Grundplatten passt.

10. Verfahren nach einem der Ansprüche 7 bis 9, wobei die vernetzbare Klebstoffzusammensetzung (15) eine Viskosität von mindestens 10 Pa·s und nicht mehr als 200 Pa·s aufweist.

**11.** Verfahren nach einem der Ansprüche 7 bis 10, wobei eine erste Ableitelektrode (11A), auf der ein Formationsmaterial des ersten elektrischen Verbinders (12A) teilweise im Voraus angeordnet ist, und eine zweite Ableitelektrode (11B), auf der ein Formationsmaterial des zweiten elektrischen Verbinders (12B) teilweise im Voraus angeordnet ist, verwendet werden.

**Revendications**

**1.** Module de cellule solaire (100) comportant :

une ou plusieurs cellules de conversion photoélectrique dans lesquelles une première électrode sur un côté d'une première plaque de base (3) et une seconde électrode sur un côté d'une seconde plaque de base (7) sont en opposition via une couche fonctionnelle,
au moins un matériau d'emballage barrière (13A, 13B) qui est scellé par un joint (14) et entoure la ou les cellules de conversion photoélectrique ;
au moins une première électrode de sortie (11A) connectée à la première électrode via un premier connecteur électrique (12A), et
une seconde électrode de sortie (11B) connectée à la seconde électrode via un second connecteur électrique (12B), dans lequel
la couche fonctionnelle est une couche d'électrolyte (4) et le module de cellule solaire (100) est un module de cellule solaire à colorant,
la première électrode de sortie (11A) et la seconde électrode de sortie (11B) incluent chacune un conducteur, et
dans lequel le au moins un joint (14) s'étend à partir du module de cellule solaire (100) jusqu'à l'extérieur du module (100), dans lequel l'une ou l'autre parmi la première électrode de sortie (11A) et la seconde électrode de sortie (11B), ou les deux, s'étendent à travers ledit joint (14) à partir du module de cellule solaire (100) jusqu'à l'extérieur du module de cellule solaire (100), et sur lesquelles un espace entre chacun des conducteurs et le matériau d'emballage barrière est rempli par un produit durci d'une composition adhésive réticulable (15), **caractérisé en ce que** chaque connecteur parmi le premier connecteur électrique (12A) et le second connecteur électrique (12B) inclut un adhésif conducteur sensible à la pression, et
le au moins un joint (14) a une épaisseur d'au moins 1 $\mu$m et non supérieure à 250 $\mu$m.

**2.** Module de cellule solaire (100) selon la revendication 1, dans lequel la première plaque de base (3) et la seconde plaque de base (7) incluent chacune un film de résine.

**3.** Module de cellule solaire (100) selon la revendication 1 ou 2, dans lequel le premier connecteur électrique (12A) et le second connecteur électrique (12B) contiennent chacun une résine conductrice (92).

**4.** Module de cellule solaire (100) selon la revendication 1 ou 2, dans lequel le premier connecteur électrique (11A) et le second connecteur électrique (11B) contiennent chacun une soudure.

**5.** Module de cellule solaire (100) selon l'une quelconque des revendications 1 à 4, dans lequel la composition adhésive réticulable (15) est une composition de résine photodurcissable.

**6.** Module de cellule solaire (100) selon l'une quelconque des revendications 1 à 6, comportant en outre une couche adhésive disposée dans au moins une partie d'un espace entre le matériau d'emballage barrière et l'une ou l'autre parmi la première plaque de base (3) et la seconde plaque de base (7), ou les deux.

**7.** Procédé de production du module de cellule solaire (100) selon l'une quelconque des revendications 1 à 6, comportant :

une étape d'application consistant à appliquer la composition adhésive réticulable (15) sur le matériau d'emballage barrière,
une étape de prise en sandwich consistant à utiliser le matériau d'emballage barrière pour prendre en sandwich une paire de plaques de base incluant la première plaque de base (3) qui inclut la première électrode de sortie (11A) et la seconde plaque de base (7) qui inclut la seconde électrode de sortie (11B) à partir de surfaces supérieure et inférieure de la paire de plaques de base, et
une étape d'adhérence étroite par pression consistant à faire étroitement adhérer le matériau d'emballage barrière au conducteur de la première électrode de sortie (11A) et au conducteur de la seconde électrode de

22

sortie (11B) via la composition adhésive réticulable (15) tout en pressant la paire de plaques de base dans une direction d'épaisseur via le matériau d'emballage de barrière en utilisant un élément de pression, dans lequel l'élément de pression est formé de caoutchouc silicone et inclut un évidement qui s'ajuste avec la paire de plaques de base dans au moins un état pressé.

8. Procédé selon la revendication 7, dans lequel l'élément de pression a une dureté plus élevée dans une zone qui ne vient pas en contact avec la paire de plaques de base que dans une zone qui vient en contact avec la paire de plaques de base.

9. Procédé selon la revendication 8, dans lequel l'élément de pression inclut un évidement qui s'ajuste avec la paire de plaques de base dans un état non pressé.

10. Procédé selon l'une quelconque des revendications 7 à 9, dans lequel la composition adhésive réticulable (15) a une viscosité d'au moins 10 Pa.s et non supérieures à 200 Pa.s.

11. Procédé selon l'une quelconque des revendications 7 à 10, dans lequel une première électrode de sortie (11A) sur laquelle un matériau de formation du premier connecteur électrique (12A) est en partie disposé à l'avance et une seconde électrode de sortie (11B) sur laquelle un matériau de formation du second connecteur électrique (12B) est en partie disposé à l'avance, sont utilisées.

# FIG. 1

FIG. 2

EP 3 496 120 B1

# FIG. 3

FIG. 4

## REFERENCES CITED IN THE DESCRIPTION

**Patent documents cited in the description**

- JP 2008186764 A
- US 2011120550 A1
- US 2010132785 A1
- WO 2006011655 A1
- JP S5312953 B
- JP S58217344 A
- JP 2000323273 A
- JP 2004025732 A
- JP 2001205743 A
- JP 2003206361 A
- JP 2006263989 A
- JP 2007030387 A
- US 6413645 B1
- US 200446497 A

**Non-patent literature cited in the description**

- **AFFINITO et al.** *Thin Solid Films,* 1996, 290, , 291